# FASCICULE DE BREVET EUROPEEN

(11) **EP 2 417 621 B1**
(45) Date de publication et mention de la délivrance du brevet: **19.12.2018**
(21) Numéro de dépôt: 10715519.4
(22) Date de dépôt: 06.04.2010
(51) Int. Cl.: H01L 21/223, H01L 21/225, H01L 21/00, C30B 31/02, C30B 31/12, C30B 31/16

(54) **PROCEDE DE DOPAGE AU BORE DE PLAQUETTES DE SILICIUM.**
VERFAHREN ZUR BORDOTIERUNG VON SILIZIUMWAFERN
METHOD FOR BORON DOPING SILICON WAFERS

(30) Priorité: 06.04.2009 FR 0901708
(43) Date de publication de la demande: 15.02.2012
(73) Titulaire: Semco Technologies S.A.S., 34090 Montpellier (FR)
(72) Inventeur: PELLEGRIN, Yvon, F-34110 Frontignan (FR)
(74) Mandataire: Cabinet Beaumont
(86) Numéro de dépôt international: PCT/EP2010/054487
(87) Numéro de publication internationale: WO 2010/115862

(56) Documents cités:
- JP-A- H0 364 912
- JP-A- 60 005 511
- US-A- 3 574 009
- US-A- 4 381 213
- GEISS V ET AL: "Mass spectrometric investigation of the reaction velocities of BCl3 and BBr3 with oxygen and water vapor in a diffusion furnace [dopant source for Si]" JOURNAL OF THE ELECTROCHEMICAL SOCIETY USA, vol. 123, no. 1, janvier 1976 (1976-01), pages 133-136, XP002560936 ISSN: 0013-4651 cité dans la demande

## Description

La présente invention appartient au domaine de la fabrication de plaquettes de silicium entrant dans le processus de réalisation de semi-conducteurs et de cellules photovoltaïques, et en particulier aux opérations de dopage des plaquettes de silicium. Elle a pour objet un procédé de dopage de type P du silicium par le bore, à l'aide du trichlorure de bore pris comme précurseur, conduit à pression réduite. Elle a également pour objet son application à la fabrication de tranches de silicium dopé au bore de grande taille.

Dans le processus d'élaboration des circuits intégrés pour l'électronique ainsi que des cellules solaires, la fabrication des semi-conducteurs repose sur des technologies basées principalement sur la modification intrinsèque du matériau silicium par dopage. Le dopage d'un matériau consiste à introduire dans sa matrice des atomes d'un autre matériau. Ces atomes vont se substituer à certains atomes initiaux et ainsi introduire davantage d'électrons ou créer des trous. L'insertion dans la maille du silicium d'éléments à déficit d'électron conduit à un matériau considéré comme positivement chargé, d'où le terme de dopage du type P. L'élément bore produit un tel type de dopage.

Le dopage est communément réalisé dans un réacteur ou four, soumis à des pression et température déterminées. L'élément dopant est introduit dans le four sous la forme d'un composé précurseur à l'état de vapeur, où il réagit avec un ou plusieurs gaz réactifs pour produire le composé dopant à proprement parler qui se dépose et diffuse le dopant dans le réseau atomique du silicium. Il est introduit dans l'enceinte du four à l'aide d'un gaz porteur qui a pour rôle de l'entraîner jusqu'à la surface des plaquettes de silicium. Pour ce faire, il est dilué dans le gaz porteur par mise en contact avec la source dudit précurseur, celle-ci pouvant être une source solide, liquide ou gazeuse.

On utilise pour la production industrielle, des fours horizontaux ou verticaux, dont l'enceinte adopte généralement la forme d'un tube cylindrique et dans laquelle les plaquettes de silicium sont disposées sur un support en quartz ou en carbure de silicium. L'une des extrémités de l'enceinte est dotée d'une porte pour permettre l'introduction des plaquettes. L'autre extrémité est obturée par une paroi terminale inamovible. Le gaz dopant, le gaz porteur et les gaz réactifs peuvent être introduits au travers d'une des parois de l'enceinte, commodément à travers la paroi terminale.

On sait que les conditions opératoires, en particulier la température et la pression, sont des paramètres critiques de la dynamique des fluides dans un réacteur, mais aussi qu'elles ont une influence déterminante sur les cinétiques réactionnelles, les composés formés pouvant être fort différents selon les choix opérés. En particulier, il faut éviter la formation de composés agressif pour le réacteur, ou nocifs pour les opérateurs, et également limiter la production de produits secondaires de réaction qui viennent perturber la qualité du dopage, encrasser l'enceinte et polluer les effluents gazeux.

Il est impératif que la circulation gazeuse soit optimum pour obtenir un mouillage homogène des plaquettes disposées dans toute la longueur du réacteur (c'est-à-dire une mise en contact du mélange gazeux avec toute les surfaces à traiter), et un dépôt uniforme sur toute la surface des plaquettes. Il est par ailleurs indispensable que l'oxydation du précurseur soit maîtrisée, afin que le composé souhaité se forme et se dépose correctement, sans provoquer la formation de produits de réaction indésirables.

Selon un des procédés de dopage les plus utilisés, dit "en tube ouvert" car réalisé dans un four à pression atmosphérique, les plaquettes de silicium sont introduites dans le four et portées à une température comprise généralement entre 800°C et 1200°C. Cette température est nécessaire pour assurer la pénétration par diffusion du dopant dans une couche superficielle de la plaquette de silicium.

Toutefois, ces procédés engendrent des risques importants de dissémination d'acide dans le four et l'environnement. Dans l'enceinte réactive cette présence d'acide issu du dopant a des répercussions sur la répétitivité du traitement des plaquettes et crée souvent des problèmes de piqûres de la surface du silicium par HCl. L'échappement éventuel de vapeurs d'acide dans l'environnement du four conduit à des arrêts de maintenance prolongés et à une perte de productivité.

En raison d'une grande déplétion d'un point à l'autre de l'enceinte, les gaz doivent être envoyés avec un grand débit pour obtenir une distribution homogène sur toutes les plaquettes, ce qui engendre une importante consommation de gaz et par suite d'effluents à traiter. Du fait de cette déplétion, pour obtenir une bonne uniformité du dopage sans accroître excessivement les coûts, les fours doivent garder des dimensions modérées, imposant de traiter des plaquettes de dimensions modestes (inférieures à 10 cm²), et un espace relativement important (supérieur à 5 mm) doit être prévu entre chaque plaquette. Le nombre de plaquettes pouvant être chargées dans le four est ainsi limité à une cinquantaine d'unités. Cette contrainte est particulièrement désavantageuse pour la fabrication de plaquettes pour les cellules solaires.

En ce qui concerne plus spécifiquement le dopage au bore, des tentatives ont été faites pour mettre au point des méthodes de dopage visant à remédier à ces difficultés. Des essais pour utiliser différentes sources de bore ont été effectués. Cependant, de nombreux obstacles sont à surmonter. L'acide borique en mélange avec du tétra-éthyl-ortho-silicate (TEOS) est à écarter car, même au degré de pureté maximum, il contient encore du fer, ce qui fait chuter les rendements. Le classique BBr₃ est un liquide toxique et nocif pour les opérateurs comme pour les équipements. Le diborane, qui est un gaz mortel, doit quant à lui être rejeté pour des raisons évidentes de sécurité. Du fait de ces inconvénients, les producteurs sont demandeurs d'une technologie utilisant un précurseur gazeux, de faible toxicité.

Le trichlorure de brome est un composé gazeux répondant à cette exigence. Il a toutefois été délaissé du fait de la difficulté à en maîtriser la réactivité. On peut mentionner à ce sujet le brevet US 4 381 213 qui décrit une méthode de dopage de plaquettes de silicium par le bore par BCl₃, celle-ci nécessitant de nombreuses étapes. Une couche d'oxyde de 50 Angstroms est d'abord formée pour protéger la surface des plaquettes des produits agressifs formés par réaction du composé borique dans les étapes suivantes. Puis une composition gazeuse contenant le précurseur borique est introduite dans le réacteur en même temps qu'un gaz oxydant, le tout réagissant sous vide contrôlé entre 6,7 Pa et 66,5 Pa, pour former une couche d'un composé boré sur les plaquettes. Enfin, une étape de chauffage provoque une redistribution du bore et son incorporation dans les plaquettes à la profondeur désirée. Toutefois, il reste encore à obtenir la re-oxydation de la couche borée pour qu'elle puisse être éliminée sans endommager la surface des plaquettes.

Certaines approches ont visé à augmenter l'espacement entre les plaquettes ou à accroître le débit gazeux, ce qui n'est pas satisfaisant comme il a été expliqué plus haut. D'autres ont recouru à un traitement sous basse pression, mais ces technologies sont très contraignantes dans leur mise en oeuvre. D'autres encore se sont tournés vers l'utilisation de technologies très différentes, telles que l'implantation ionique, aux caractéristiques économiques et industrielles très lourdes et inadaptées pour les applications visées ici.

Ainsi, il existe un besoin exprimé depuis de nombreuses années et non satisfait jusqu'à ce jour, de disposer d'une technologie permettant de réaliser un dopage du silicium par le bore qui soit homogène, reproductible et fiable, et qui permette de traiter en un cycle plus d'une centaine de plaquettes de grande taille, avec une consommation modérée de gaz.

La présente invention a pour objectif de résoudre les problèmes sus évoqués pour répondre à ce besoin, en proposant un nouveau procédé de dopage du silicium par le bore.

Le procédé proposé présente l'avantage de fonctionner à pression réduite, c'est-à-dire à une pression sub-atmosphérique, mais cependant très supérieure aux pressions des procédés relevant des technologies de LPCVD (pour Low Pressure Chemical Vapor Déposition) qui sont de l'ordre de quelques pascals. Les conditions opératoires définies permettent de mettre en oeuvre le trichlorure de bore BCl₃, (aussi appelé trichloroborane), un gaz considéré comme ayant une réactivité difficilement maîtrisable, en tant que composé précurseur de l'élément dopant. Grâce à la mise au point de ces conditions opératoires particulières, il est désormais possible de réaliser un dopage au bore à l'aide d'un gaz précurseur qui présente l'avantage d'être relativement facile à manipuler pour les utilisateurs. Un autre avantage du procédé proposé repose sur un mélange intime des gaz dans un certain ordre, qui favorise un dépôt uniforme sur l'ensemble des plaquettes. Les performances ainsi atteintes ouvrent la possibilité de réaliser le dopage de plaquettes de grande taille et en grandes quantités, qui sont utilisables en particulier pour la fabrication des cellules photovoltaïques, avec un excellent rendement et dans des conditions de sécurité inégalées.

Les autres contraintes industrielles pour réaliser l'oxydation du précurseur et le dépôt puis la diffusion du bore dans la couche de silicium sont respectées et aboutissent à un dopage de haute qualité des plaquettes traitées.

Ainsi, la présente invention a pour objet un procédé de dopage par le bore de plaquettes de silicium placées sur un support dans l'enceinte d'un four dont une extrémité comporte une paroi dans laquelle sont ménagés des moyens d'introduction des gaz réactifs et d'un gaz porteur d'un précurseur du bore sous forme gazeuse, ledit procédé comprenant les étapes consistant à :
a) - faire réagir dans l'enceinte les gaz réactifs avec du trichlorure de bore BCl₃ dilué dans le gaz porteur à une pression comprise entre 1 kPa et 30 kPa, et à une température comprise entre 800 °C et 1100 °C, pour former une couche de verre d'oxyde de bore B₂O₃,
b) - réaliser la diffusion du bore atomique dans le silicium sous atmosphère N₂+O₂ à une pression comprise entre 1 kPa et 30 kPa.

Le procédé est réalisé dans un four, adoptant par exemple la forme d'un tube cylindrique communément horizontal, pourvu d'une enceinte fermée hermétiquement par une porte et dans laquelle sont introduites les plaquettes. Le four comporte des tubulures d'injection des gaz dans l'enceinte dans des conditions de débit et de pression parfaitement contrôlées, pour accomplir les étapes susvisées. L'extraction des gaz est assurée par un conduit supplémentaire aménagé dans la paroi du réacteur. L'ouverture de ce conduit est située à l'extrémité opposée aux conduits d'injection des gaz, de préférence coté porte. Des moyens de chauffage, constitués par exemple par des résistances électriques, sont répartis autour de l'enceinte à écartement de cette dernière ou bien à son contact.

Le four est pourvu de moyens d'extraction des gaz, comprenant des moyens d'aspiration reliés au susdit conduit d'évacuation, contribuant à créer dans l'enceinte une dépression constante et contrôlée. Cette aspiration permet d'orienter et de maintenir la vitesse des gaz dans l'enceinte tout en évacuant constamment les effluents, de façon à déplacer favorablement d'éventuels équilibres chimiques lors des réactions. Ces moyens d'extraction des gaz ont pour composant essentiel une pompe à membrane dont les organes en contact avec les gaz sont constitués d'un composé polymère perfluoré. De la même façon, tous les éléments en contact avec les gaz réactifs sont en polymère perfluoré, en quartz, ou en carbure de silicium.

Selon le procédé, dans un premier temps, la décomposition du précurseur du bore produit un composé oxydé B₂O₃ qui se dépose sous forme de verre sur le silicium des plaquettes et, dans un deuxième temps, il y a diffusion d'atomes de bore dans le silicium et modification locale de ses propriétés semi-conductrices, cette étape réalisant le dopage du silicium à proprement parler.

Ces deux étapes sont conduites à des niveaux de pression dits sub-atmosphériques, et sont compatibles avec des moyens relativement simples pour la création de la dépression, à la différence des outils et procédés mis en oeuvre dans les technologies basse pression telles que la LPCVD et dans les technologies atmosphériques.

Les gaz réactifs désignent aux fins de la présente description, les gaz qui réagissent avec le gaz précurseur (à l'exclusion du gaz précurseur lui-même). Typiquement, par soucis de clarté et bien que d'autres gaz puissent être utilisés, les gaz réactifs mentionnés ici seront l'oxygène et l'hydrogène, le gaz porteur étant l'azote. Le gaz porteur peut être introduit dans l'enceinte alors qu'il contient ou non le gaz précurseur, selon l'étape du procédé concernée, ce qui sera précisé si le contexte ne le rend pas évident. Les principales caractéristiques des réactions chimiques concernées et en particulier leur cinétique, ont été publiées par V. Geiss et E. Fröschle dans J. Electrochem. Soc. : Solid State Science and Technology, Jan 1976, p133 à 136.

Il est souligné également que les grandeurs physiques (température, pression, débits, etc.) sont données par référence aux conditions normales de température et de pression.

Selon un mode de réalisation particulier de l'invention, à l'étape b), la pression dans l'enceinte est comprise entre 15 kPa et 30 kPa (soit entre 150 mbar et 300 mbar). Ainsi, lors de cette seconde phase du procédé, on peut soit maintenir une pression identique à celle de la première phase, soit l'accroître si l'on souhaite accélérer la diffusion du dopant dans le réseau de silicium, sans nuire à la qualité recherchée du produit final.

Selon une autre caractéristique préférée du procédé objet de l'invention, durant les étapes a) et b), la température dans la zone de l'enceinte au voisinage des plaquettes est comprise entre 900°C et 1000°C. On s'intéresse ici spécifiquement à la zone de traitement, c'est-à-dire à la zone du four où sont placées les plaquettes durant le cycle et où se produit le dépôt du précurseur, les autres segments du four pouvant être régulés en température de manière différente comme on le verra plus loin.

Dans un mode de réalisation avantageux de la présente invention à l'étape a), le trichlorure de bore est apporté dans l'enceinte à raison de 20 cm³/mn à 100 cm³/mn. De préférence, il est introduit dans l'enceinte avec un débit représentant environ le quart du débit de l'oxygène injecté.

Comme déjà indiqué, le trichlorure de bore est distribué à l'aide d'un gaz porteur, celui-ci étant un gaz neutre, par exemple de l'azote ou de l'argon. D'une façon inattendue, il est apparu que le facteur de dilution pouvait être très large. Ainsi, selon l'invention, le trichlorure de bore est dilué dans le gaz porteur à une concentration comprise entre 3% et 95% en volume.

Selon une autre caractéristique intéressante du procédé objet de l'invention, le débit gazeux total dans l'enceinte est inférieur à 5 litres par minute.

Selon une caractéristique avantageuse du procédé objet de l'invention, les gaz réactifs et le gaz porteur du trichlorure de bore sont introduits dans une zone libre ménagée dans la section de l'enceinte comprise entre la paroi d'extrémité et la zone de traitement accueillant les plaquettes, où ils se mélangent avant de balayer et de mouiller lesdites plaquettes, la zone libre occupant avantageusement de 10% à 20% du volume total de l'enceinte.

En effet, si le mélange des gaz est effectué *ex situ*, c'est-à-dire avant leur injection dans l'enceinte, les réactions sont difficilement maîtrisables du fait de la grande réactivité des composés en jeu. A contrario, lorsque le mélange des gaz est effectué au niveau des plaquettes, l'homogénéité du dopage est très mauvaise et la reproductibilité incertaine. Le dépôt d'oxyde est satisfaisant lorsque le mélange des gaz réactifs avec le précurseur est réalisé *in situ*, c'est-à-dire dans l'enceinte même, au niveau de l'espace libre dépourvu de plaquettes, ménagé à cet effet. Ce volume libre est ainsi apparu nécessaire et suffisant pour effectuer de manière optimale le mélange des différents gaz devant réagir ensemble afin de réaliser le dépôt de l'oxyde de bore. De préférence, pour des raisons de mise en oeuvre, cette zone libre est située du côté opposé à l'extrémité du four muni de la porte.

Conformément à une autre caractéristique avantageuse du procédé selon l'invention, durant l'étape a), la température dans la zone libre de l'enceinte est inférieure de 5% à 15%, de préférence d'environ 10%, à la température de la zone traitement. Les moyens de chauffage de l'enceinte ici utilisés sont de manière connue composés de plusieurs éléments indépendants permettant la réalisation d'un profil thermique longitudinal adaptable et contrôlable. L'un de ces éléments est placé au niveau de la zone libre, et est contrôlé de manière séparée, de sorte à obtenir une température plus basse dans cette zone libre que dans la zone de traitement de l'enceinte.

De manière intéressante, dans le procédé selon la présente invention, les gaz réagissant avec le précurseur sont l'oxygène et l'hydrogène, le gaz porteur est l'azote, et chacun desdits gaz est introduit dans l'enceinte par un conduit distinct. Il va de soi que le gaz porteur est chargé du précurseur durant le traitement, mais peut être introduit seul lors des opérations annexes au traitement lui-même.

Ainsi, contrairement à d'autres techniques, les gaz réactifs et le précurseur du dopant (H₂, O₂ et BCl₃) sont injectés séparément et n'interagissent qu'à partir du moment où ils pénètrent dans l'enceinte à une température donnée. Le mélange est d'autant plus performant qu'il peut se réaliser avant d'atteindre les plaquettes, dans une zone libre et moins chaude. Ceci offre l'intérêt d'homogénéiser le mélange N₂-BCl₃ et H₂ avant d'initier les réactions chimiques conduisant à l'oxydation et au dépôt du précurseur. Il est ainsi possible d'obtenir une meilleure maîtrise des cinétiques réactionnelles qui se déroulent uniquement dans l'enceinte.

Selon une caractéristique préférée du procédé objet de l'invention, l'hydrogène et le gaz porteur chargé ou non du précurseur borique sont introduits dans la zone libre de l'enceinte au voisinage de la paroi d'extrémité, et l'oxygène est introduit au voisinage de la zone de traitement. Ainsi, le gaz précurseur dilué dans le gaz porteur et l'hydrogène se mélangent avant de réagir avec l'oxygène, au voisinage de la zone la plus chaude, au plus prés de l'emplacement occupé par les plaquettes. Par ailleurs, les gaz sont évacués par un conduit d'extraction dont l'orifice s'ouvre à l'opposé de la paroi d'extrémité, ledit conduit étant lié à une unité d'aspiration dotée d'un système de régulation et de contrôle de la pression régnant dans l'enceinte. Les cinétiques réactionnelles sont apparues améliorées par ce dispositif.

Selon un mode particulier de mise en oeuvre de la présente invention, à l'étape a), les gaz sont introduits dans l'enceinte dans les proportions volumiques suivantes :
- gaz porteur + précurseur du bore : de 55 % à 80 %,
- hydrogène : de 0,5% à 15%
- oxygène : de 15 % à 30 %,
Ces proportions particulières illustrent une combinaison de valeurs possibles parmi d'autres pour réaliser une couche de silicium dopée au bore, répondant aux exigences d'homogénéité et d'uniformité requises. Par exemple, on peut employer 1/4 d'oxygène, 1/8 d'hydrogène et 5/8 de gaz porteur + précurseur. Il est apparu en outre de manière inattendue, qu'une faible quantité d'hydrogène suffisait à une réalisation tout à fait satisfaisante du procédé.

En outre, de manière avantageuse, le procédé selon l'invention comprend une étape précédant l'étape a), au cours de laquelle on stabilise les paramètres opératoires des gaz réactifs et du gaz porteur, à savoir débits, pression, flux, températures. Durant cette étape qui est brève (elle dure quelques dizaines de secondes), il se produit une oxydation humide superficielle du silicium, ce qui évite la formation indésirable de composés de type SiyBx lors de la mise en contact du précurseur et du silicium. La vapeur d'eau est formée par réaction de l'oxygène avec l'hydrogène.

Pour la réalisation du procédé selon l'invention, l'homme du métier fixera les temps de dépôt du précurseur et de diffusion du bore en fonction des résultats recherchés en terme de concentration de l'élément dopant et de profondeur de pénétration dans le silicium. Par exemple, l'étape a) de dépôt d'une couche de verre d'oxyde de bore B₂O₃ peut être conduite durant de 5 mn à 30 mn environ, et l'étape b) de diffusion du bore atomique peut durer de 10 mn à 30 mn environ.

Au niveau du fonctionnement industriel, le procédé tel qu'il vient d'être décrit est particulièrement performant, car il offre une reproductibilité élevée, y compris suite aux redémarrages après arrêts. Aucun excédent (overdose) de dopants ni aucun effet mémoire n'ont été observés. En comparaison avec les technologies atmosphériques ou LPCVD, la propreté périphérique est satisfaisante, la fréquence des nettoyages est fortement diminuée. De ce fait, les temps maintenance sont significativement raccourcis, et plus généralement les coûts de fonctionnement réduits en proportion.

Le procédé ici revendiqué peut avantageusement être mis en oeuvre dans un four dont le modèle général est celui des fours utilisés dans les technologies voisines pour le dopage sous pression réduite, en particulier en ce qui concerne les moyens d'obtention de la dépression par une pompe à membrane et le contrôle et la régulation de cette dépression, tels que celui décrit dans la demande de brevet FR 2 824 663, mais comportant des caractéristiques propres à répondre aux particularités du dopage au bore dans les conditions spécifiées plus haut.

C'est pourquoi, on décrit également un four pour le dopage par le bore de plaquettes de silicium placées sur un support, comprenant une enceinte dont une extrémité comporte une paroi dans laquelle sont ménagés des moyens d'introduction des gaz réactifs et d'un gaz porteur d'un précurseur du bore sous forme gazeuse, ledit four étant caractérisé en ce que l'enceinte comprend une zone de réception du support des plaquettes, dite zone de traitement, et une zone libre ménagée entre ladite paroi d'extrémité et ladite zone de réception du support des plaquettes, ladite zone libre occupant de 10% à 20% du volume total de l'enceinte.

Le four est avantageusement muni de moyens de chauffage de l'enceinte composés de plusieurs éléments indépendants permettant la réalisation d'un profil thermique longitudinal adaptable et contrôlable, l'un au moins de ces éléments étant dédié au chauffage spécifique de la zone libre. De manière optimale, on dispose cinq éléments le long de la paroi de l'enceinte, chacun étant muni de capteurs et de moyens de réguler la température dans le segment du four correspondant. Cette disposition évite l'apparition de différences thermiques le long de la zone de traitement du four, notamment au niveau de la porte, tout en permettant comme on le souhaite ici, de réduire la température à l'extrémité de l'enceinte.

Selon une caractéristique préferée, ledit four comporte deux conduits distincts l'un pour l'introduction d'un premier gaz réactif, par exemple de l'hydrogène, et l'autre pour l'introduction du gaz porteur (et du précurseur du bore), ceux-ci débouchant dans la zone libre au voisinage de la paroi d'extrémité, et un conduit pour l'introduction d'un second gaz réactif, par exemple de l'oxygène, débouchant au voisinage de la zone de traitement. Il comporte également un conduit d'extraction des gaz dont l'orifice s'ouvre à l'opposé de la paroi d'extrémité, ledit conduit étant lié à une unité d'aspiration dotée d'un système de régulation et de contrôle de la pression régnant dans l'enceinte.

Le procédé qui vient d'être décrit répond aux exigences de qualité et d'efficacité recherchées par les producteurs de plaquettes de silicium dopé. En particulier, cette technologie est compatible avec nombre d'équipements utilisés jusqu'à présent. Elle assure une excellente uniformité du traitement sur toute la surface d'une même plaquette, sur chaque plaquette d'une même charge (lot de plaquettes chargées sur le support), ainsi que de charge à charge. Elle permet en outre le traitement de plaquettes sans limitation de taille, ce qui constitue un avantage certain, notamment pour les applications photovoltaïques.

C'est pourquoi est également objet de la présente invention, l'application du procédé tel que décrit ci-dessus à la création de jonctions de type P sur des tranches de silicium de surface allant de 50 cm² à 700 cm². On obtient des tranches de silicium rondes ou carrées, dopées au bore, dont la surface correspond à celle des plaquettes de dimensions classiques actuelles.

La technologie ici décrite présente en outre l'avantage d'autoriser la fabrication de plaques conductrices dopées plus fine et qui consomment donc moins de silicium. Est revendiquée l'application du procédé précédemment décrit pour la production de tranches de silicium dopées au bore, d'épaisseur comprise entre 100 µm et 150 µm. La combinaison d'une taille élevée et d'une épaisseur réduite des plaques de silicium dopées au bore rend celles-ci particulièrement adaptées à leur utilisation dans le domaine de la fabrication des cellules photovoltaïques. Elle autorise en particulier la fabrication de plaques semi-conductrices consommant moins de silicium, ce qui est décisif dans un contexte d'approvisionnement aléatoire en matière première.

Le procédé inventif trouve en effet son application pour la réalisation des jonctions de type P sur des lots d'une ou de plusieurs centaines de tranches de silicium disposées sur leur support à intervalle inférieur ou égal à 5 mm. En effet, les performances atteintes par le présent procédé sont telles qu'il devient possible de traiter de manière homogène en un seul cycle un grand nombre de plaquettes, mêmes si elles sont disposées avec un espacement réduit entre elles. Ceci représente un atout industriel indiscutable.

Cette invention est finalement applicable pour tout développement technique dans le domaine de la fabrication des cellules photovoltaïques, ou autre, nécessitant un dopage P au bore, avec une grande productivité, et permet notamment la fabrication des plaques photovoltaïques bifaces.

En outre, le procédé tel que décrit peut avantageusement s'appliquer à la production de tranches de silicium dopées au bore destinées à la fabrication de cellules photovoltaïques à partir de silicium N de qualité métallurgique.

D'autres avantages et caractéristiques de l'invention apparaîtront à la lecture de la description ci-après d'une forme de réalisation donnée à titre d'exemple non limitatif.

### EXEMPLE 1

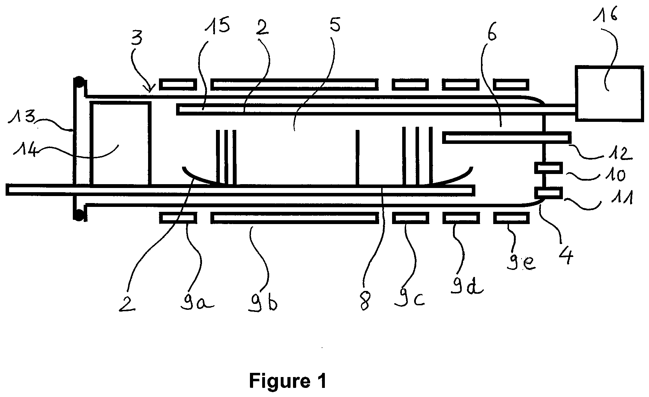

La Figure 1 présente une vue schématique en coupe d'un four, pour le traitement de plaquettes de silicium.

Le four selon la Figure 1 est doté de l'enceinte étanche 3 associée aux moyens de chauffage 9, dans laquelle sont introduites les plaquettes de silicium 1 placées sur le support 2 et devant subir le traitement. L'enceinte 3, de forme cylindrique, est fermée hermétiquement à ses extrémités par la paroi terminale fixe 4 et par la porte 13 protégée par le bouchon thermique 14 en quartz opaque d'un diamètre légèrement inférieur à celui du tube. L'enceinte comprend la zone de traitement 5 et la zone libre 6. Les plaquettes 1 sont disposées dans l'enceinte 3 du four de manière transversale à la direction d'écoulement des gaz.

Les moyens de chauffage 9, installés autour de l'enceinte 3 sont constitués de 5 segments indépendants 9a-9e, permettant la réalisation d'un profil thermique longitudinal adaptable et contrôlable. Le segment 9e du dispositif de chauffage est à l'aplomb de la zone libre 6.

Le four comporte les trois conduits 10, 11, 12 d'introduction des gaz dans l'enceinte 3, et le conduit 15 d'extraction des effluents gazeux, qui est relié à l'unité d'aspiration 16, cette unité d'aspiration étant située à distance du four dans une zone tempérée. L'unité d'aspiration 16 comprend une pompe aspirante refoulante, avantageusement du type à membrane, réalisée, au moins pour ses organes en contact avec les gaz, en une matière apte à résister à la corrosion, par exemple à base d'un polymère perfluoré tel que le polytétrafluoroéthylène (PTFE) ou le perfluoroalkoxy (PFA), plus connus sous le nom commercial générique de TEFLON. L'unité d'aspiration 16 comporte aussi des organes de contrôle et de régulation de la dépression dans l'enceinte du four.

Les conduits 10, 11, 12 d'introduction des gaz dans l'enceinte traversent de part en part la paroi d'extrémité 4 et débouchent dans la zone libre 6. Le conduit 15 d'extraction des gaz traverse également la paroi terminale 4, mais il prend naissance à l'extrémité opposée de l'enceinte. Le premier conduit 11 introduit de l'hydrogène au voisinage de la paroi 4, et le deuxième conduit 12 introduit le mélange N₂-BCl₃ aussi au voisinage de la paroi 4, pour éviter le craquage anticipé du mélange H₂, N₂-BCl₃. Le conduit 12 introduit dans l'enceinte 3 de l'oxygène. Ce conduit débouche dans l'enceinte 3 au niveau de la zone de traitement 5, à proximité de l'emplacement occupé par le support 2 des plaquettes 1.

### EXEMPLE 2

Le présent exemple décrit un cycle de traitement d'un lot de plaquettes de silicium par un mode de réalisation particulier du procédé de dopage par le bore selon l'invention.

Le traitement se fait dans un four tel que décrit à l'exemple précédent. Le support 2 est chargé de 400 plaquettes de silicium de 150 mm de diamètre, et est placé dans la zone de traitement 5 de l'enceinte 3. La porte 13 est fermée hermétiquement et le dispositif de chauffage 9 permet d'atteindre une température régulée de 960°C pour la zone de traitement 5 et 880°C dans la zone libre 6. Au bout de quelques minutes, les gaz réactifs sont admis dans l'enceinte, pour une stabilisation de la pression et du débit. La pression est fixée à 30 kPa.

Le gaz porteur est l'azote, le précurseur du bore est le trichlorure de bore BCl₃ gazeux. Les gaz réactifs sont l'oxygène et l'hydrogène. L'injection se poursuit 15 mn, avec un débit total de l'ordre de 5 litres de gaz par minute, dans les proportions suivantes :

| | |
|---|---|
| BCl₃: | 1 vol/min |
| O₂: | 4 vol/min |
| N₂ et H₂ : | complément volumique |

Le gaz actif BCl₃ est mélangé initialement à l'azote dans des proportions rigoureuses grâce à l'utilisation d'un dispositif de contrôle de flux de masse. La pression de ce mélange est ajustée et contrôlée à environ une atmosphère. Une vanne installée entre ce dispositif et les conduits d'introduction des gaz assure la perte de charge nécessaire pour obtenir la pression souhaitée dans l'enceinte du réacteur. De la même façon, la composition et les débits et pressions d'hydrogène et d'oxygène sont rigoureusement ajustés et contrôlés. A l'issue de cette étape, une couche d'oxyde de bore B₂O₃, s'est déposée à la surface des tranches.

La phase de diffusion est alors conduite durant 30 mn de la manière suivante : la température est maintenue à 960°C, et la pression est amenée à 250 mbar pour un meilleur échange thermique assurant une uniformité des températures et donc une uniformité de la diffusion. Le débit d'azote et d'oxygène est maintenu au même niveau qu'à l'étape précédente.

A l'issu du cycle complet de traitement, les plaquettes sont testées pour différentes propriétés. Les mesures effectuées à l'ellipsomètre indiquent que le verre formé en surface des plaquettes contient des atomes de bore sur une épaisseur de 1300 Angström. L'indice de réfraction est de 1,475 +/-0,025. Les mesures d'uniformité sont réalisées en neuf points de trois plaquettes par lot. On obtient un taux d'uniformité inférieur à 5%, aussi bien de point à point sur une plaque, de plaque à plaque sur un lot, que de lot à lot.

On constate donc que les résultats du dopage au bore du silicium réalisé dans les conditions définies ci-dessus conformément à la présente invention sont excellents, d'autant que les plaquette traitées sont de grande taille et que 400 plaquettes ont été dopées en un seul chargement.

## Revendications

1. Procédé de dopage par le bore de plaquettes de silicium (1) placées sur un support (2) dans l'enceinte (3) d'un four dont l'extrémité comporte une paroi (4) dans laquelle sont ménagés des moyens d'introduction des gaz réactifs et d'un gaz porteur d'un précurseur du bore sous forme gazeuse, **caractérisé en ce qu'**il comprend les étapes consistant à :
a) - faire réagir dans l'enceinte (3) les gaz réactifs avec du trichlorure de bore BCl₃ dilué dans le gaz porteur, à une pression comprise entre 1 kPa et 30 kPa et à une température comprise entre 800°C et 1100°C, pour former une couche de verre d'oxyde de bore B₂O₃,
b) - réaliser la diffusion du bore dans le silicium sous atmosphère de N₂ + O₂ à une pression comprise entre 1 kPa et 30 kPa.

2. Procédé selon la revendication 1, **caractérisé en ce que**, à l'étape b), la pression dans l'enceinte (3) est comprise entre 15 kPa et 30 kPa.

3. Procédé selon l'une des revendications 1 ou 2, **caractérisé en ce que** durant les étapes a) et b), la température dans la zone de l'enceinte au voisinage des plaquettes (1), dite zone de traitement (5), est comprise entre 900°C et 1000°C.

4. Procédé selon l'une des revendications précédentes, **caractérisé en ce que**, à l'étape a), le trichlorure de bore est apporté dans l'enceinte (3) à raison de 20 cm³/mn à 100 cm³/mn, représentant de préférence environ le quart du débit de l'oxygène injecté.

5. Procédé selon l'une des revendications précédentes, **caractérisé en ce que** le trichlorure de bore est dilué dans le gaz porteur à une concentration comprise entre 3 % et 95 % en volume.

6. Procédé selon l'une des revendications précédentes, **caractérisé en ce que** le débit gazeux total dans l'enceinte (3) est inférieur à 5 litres par minute.

7. Procédé selon l'une quelconque des revendications précédentes, **caractérisé en ce que** les gaz réactifs et le gaz porteur du trichlorure de bore sont introduits dans une zone libre (6) ménagée dans la section de l'enceinte (3) comprise entre ladite paroi d'extrémité (4) et la zone de traitement (5) accueillant les plaquettes (1), où ils se mélangent avant de mouiller lesdites plaquettes, ladite zone libre (6) occupant de 10 % à 20 % du volume total de l'enceinte (3).

8. Procédé selon la revendication 7, **caractérisé en ce que**, durant l'étape a), la température dans la zone libre (6) de l'enceinte est inférieure de 5 % à 15 %, de préférence d'environ 10 %, à la température de la zone de traitement (5).

9. Procédé selon l'une quelconque des revendications précédentes, **caractérisé en ce que** les gaz réagissant avec le précurseur sont l'oxygène et l'hydrogène, le gaz porteur est l'azote ou l'argon, chacun desdits gaz étant introduit dans l'enceinte par un conduit distinct (7', 7", 7'").

10. Procédé selon la revendication précédente, **caractérisé en ce que** l'hydrogène et le gaz porteur du trichlorure de bore sont introduits dans l'enceinte au voisinage de la paroi (4), et l'oxygène est introduit dans la zone libre au voisinage de la zone de traitement (5).

11. Procédé selon l'une des revendications précédentes, **caractérisé en ce que** à l'étape a), les gaz sont introduits dans l'enceinte (3) dans les proportions volumiques suivantes :
- gaz porteur + précurseur du bore : de 55 % à 80 %,
- hydrogène : de 0,5 % à 15 %,
- oxygène : de 15 % à 30 %.

12. Procédé selon l'une quelconque des revendications précédentes, **caractérisé en ce que** avant l'étape a), on stabilise les paramètres opératoires des gaz réactifs et du gaz porteur, à savoir débits, pression, flux, températures, pendant quelques dizaines de secondes.

13. Application du procédé selon l'une des revendications 1 à 12, à la création de jonctions de type P sur des tranches de silicium de surface allant de 50 cm² à 700 cm².

14. Application du procédé selon l'une des revendications 1 à 12, pour la production de tranches de silicium dopées au bore, d'épaisseur comprise entre 100 µm et 150 µm.

15. Application du procédé selon l'une des revendications 1 à 12, pour la réalisation de jonctions de type P sur des lots d'une ou de plusieurs centaines de tranches de silicium disposées sur leur support à intervalle inférieur ou égal à 5 mm.

16. Application selon l'une des revendications 13 à 15, pour la production de tranches de silicium dopé au bore destinées à la fabrication de cellules photovoltaïques à partir de silicium N de qualité métallurgique.

## Patentansprüche

1. Ein Verfahren zur Bor-Dotierung von Siliziumwafern (1), die auf einem Träger (2) in der Kammer (3) eines Ofens angeordnet sind, wobei ein Ende des Ofens eine Wand (4) aufweist, in der Mittel zum Einbringen reaktiver Gase und eines Trägergases, der einen Bor-Präkursor in gasförmiger Form trägt, angeordnet sind, **dadurch gekennzeichnet, dass** das Verfahren die folgenden Schritte aufweist:
a) -in der Kammer (3) Reagieren der reaktiven Gase mit Bortrichlorid BCl₃, das im Trägergas verdünnt ist, bei einem Druck zwischen 1 kPa und 30 kPa und bei einer Temperatur zwischen 800°C und 1100°C, um eine Boroxid-B₂O₃-Glasschicht zu bilden,
b) -Durchführen der Diffusion von Bor in Silizium unter einer N₂ + O₂-Atmosphäre bei einem Druck zwischen 1 kPa und 30 kPa.

2. Verfahren nach Anspruch 1, **dadurch gekennzeichnet, dass** in Schritt b) der Druck in der Kammer (3) zwischen 15 kPa und 30 kPa liegt.

3. Verfahren nach einem der Ansprüche 1 oder 2, **dadurch gekennzeichnet, dass** während der Schritte a) und b) die Temperatur in der Zone der Kammer in der Nähe der Wafer (1), die Behandlungszone (5) genannt wird, zwischen 900°C und 1000°C liegt.

4. Verfahren nach einem der vorhergehenden Ansprüche, **dadurch gekennzeichnet, dass** in Schritt a) das Bortrichlorid in die Kammer (3) mit einer Rate von 20 cm³/min bis 100 cm³/min, die vorzugsweise ungefähr ein Viertel der Flussrate des eingelassenen Sauerstoffs repräsentiert, vorgesehen wird.

5. Verfahren nach einem der vorhergehenden Ansprüche, **dadurch gekennzeichnet, dass** das Bortrichlorid in dem Trägergas auf eine Konzentration zwischen 3 Vol.% und 95 Vol.% verdünnt wird.

6. Verfahren nach einem der vorhergehenden Ansprüche, **dadurch gekennzeichnet, dass** die Gesamtgasflussrate in der Kammer (3) weniger als 5 Liter pro Minute beträgt.

7. Verfahren nach einem der vorhergehenden Ansprüche, **dadurch gekennzeichnet, dass** die reaktiven Gase und das Gas, das Bortrichlorid trägt, in eine Freizone (6) eingeleitet werden, die in dem Abschnitt der Kammer (3) zwischen der Endwand (4) und der Behandlungszone (5), die die Wafer (1) aufnimmt, angeordnet ist, wobei die Gase vor dem Benetzen der Wafer vermischen werden, wobei die Freizone (6) 10% bis 20% des Gesamtvolumens der Kammer (3) einnimmt.

8. Verfahren nach Anspruch 7, **dadurch gekennzeichnet, dass** während Schritt a) die Temperatur in der Freizone (6) der Kammer 5% bis 15% geringer ist, vorzugsweise etwa 10% geringer als die Temperatur der Behandlungszone (5).

9. Verfahren nach einem der vorhergehenden Ansprüche, **dadurch gekennzeichnet, dass** die mit dem Präkursor reagierenden Gase Sauerstoff und Wasserstoff sind, und das Trägergas Stickstoff oder Argon ist, wobei jedes der Gase durch eine separate Leitung (7, 7", 7'") in die Kammer eingeleitet wird.

10. Verfahren nach einem der vorhergehenden Ansprüche, **dadurch gekennzeichnet, dass** der Wasserstoff und das Gas, das Bortrichlorid trägt, in die Kammer in der Nähe der Wand (4) eingeleitet werden und der Sauerstoff in die Freizone in der Nähe der Behandlungszone (5) eingeleitet wird.

11. Verfahren nach einem der vorhergehenden Ansprüche, **dadurch gekennzeichnet, dass** in Schritt a) die Gase in den folgenden Volumenanteilen in die Kammer (3) eingeleitet werden:
- Trägergas + Bor-Präkursor: 55% bis 80%,
- Wasserstoff: 0,5% bis 15%,
- Sauerstoff: 15% bis 30%.

12. Verfahren nach einem der vorhergehenden Ansprüche, **dadurch gekennzeichnet, dass** vor Schritt a) die Betriebsparameter der reaktiven Gase und des Trägergases, nämlich Strömungsraten, Druck, Strömungen und Temperaturen, für einige Zehnsekunden stabilisiert werden.

13. Eine Anwendung für das Verfahren nach einem der Ansprüche 1 bis 12 für die Herstellung von P-Typ-Übergängen auf Siliziumscheiben mit einem Oberflächengebiet, das von 50 cm² bis 700 cm² reicht.

14. Anwendung nach einem der Ansprüche 1 bis 12 für die Produktion von Bordotierten Siliziumscheiben mit einer Dicke von zwischen 100 µm und 150 µm.

15. Anwendung nach einem der Ansprüche 1 bis 12 für die Herstellung von P-Typ-Übergängen für Chargen von hundert oder einigen hundert Siliziumscheiben, die auf ihrem Träger in einem Intervall von weniger als oder gleich 5mm angeordnet sind.

16. Anwendung nach einem der Ansprüche 13 bis 15 für die Produktion von Bordotierten Siliziumscheiben für die Herstellung von Photovoltaikzellen, die aus Silizium mit metallurgischem Grad N ausgebildet sind.

## Claims

1. A method for boron doping of silicon wafers (1) placed on a support (2) in the chamber (3) of a furnace of which one end comprises a wall (4) in which means for introducing reactive gases and a carrier gas carrying a boron precursor in gaseous form are located, **characterized in that** it comprises the steps that consist in:
a)-in the chamber (3), reacting the reactive gases with boron trichloride BCl₃ that is diluted in the carrier gas at a pressure of between 1 kPa to 30 kPa, and at a temperature of between 800 °C to 1100 °C, for forming a boron oxide B₂O₃ glass layer,
b)-carrying out the diffusion of boron in silicon under an N₂ + O₂ atmosphere at a pressure of between 1 kPa and 30 kPa.

2. The method according to claim 1, **characterized in that**, in step b), the pressure in the chamber (3) is between 15 kPa and 30 kPa.

3. The method according to one of claims 1 or 2, **characterized in that**, during steps a) and b), the temperature in the zone of the chamber in the vicinity of the wafers (1), called treatment zone (5), is between 900 °C and 1000 °C.

4. The method according to one of the preceding claims, **characterized in that**, in step a), the boron trichloride is provided in the chamber (3) at a rate of 20 cm³/minute to 100 cm³/minute, preferably representing approximately one-quarter of the flow rate of the injected oxygen.

5. The method according to one of the preceding claims, **characterized in that** the boron trichloride is diluted in the carrier gas to a concentration of between 3% and 95% by volume.

6. The method according to one of the preceding claims, **characterized in that** the total gaseous flow rate in the chamber (3) is less than 5 liters per minute.

7. The method according to any preceding claim, **characterized in that** the reactive gases and the gas carrying boron trichloride are introduced into a free zone (6) that is located in the section of the chamber (3) between said end wall (4) and the treatment zone (5) that accommodates the wafers (1), where the gases are mixed before wetting said wafers, with said free zone (6) occupying 10% to 20% of the total volume of the chamber (3) .

8. The method according to claim 7, **characterized in that**, during step a), the temperature in the free zone (6) of the chamber is 5% to 15% less, preferably approximately 10% less, than the temperature of the treatment zone (5).

9. The method according to any preceding claim, **characterized in that** the gases that react with the precursor are oxygen and hydrogen, and the carrier gas is nitrogen or argon, with each of said gases being introduced into the chamber by a separate pipe (7, 7", 7'").

10. The method according to the preceding claim, **characterized in that** hydrogen and the gas carrying boron trichloride are introduced into the chamber in the vicinity of the wall (4), and the oxygen is introduced into the free zone in the vicinity of the treatment zone (5).

11. The method according to one of the preceding claims, **characterized in that**, in stage a), the gases are introduced into the chamber (3) in the following volumetric proportions:
- carrier gas + precursor of boron: 55% to 80%,
- hydrogen: 0.5% to 15%,
- oxygen: 15% to 30%.

12. The method according to any preceding claim, **characterized in that**, before stage a), the operating parameters of the reactive gases and the carrier gas - namely flow rates, pressure, fluxes, and temperatures - are stabilized for several tens of seconds.

13. An application of the method according to one of claims 1 to 12, to the creation of P-type junctions on silicon slices with a surface area that ranges from 50 cm² to 700 cm².

14. An application of the method according to one of claims 1 to 12, for the production of boron-doped silicon slices, with a thickness of between 100 µm and 150 µm.

15. An application of the method according to one of claims 1 to 12, for the creation of P-type junctions on lots of one hundred or several hundred silicon slices placed on their support at an interval of less than or equal to 5 mm.

16. The application according to one of claims 13 to 15, for the production of boron-doped silicon slices designed for the manufacturing of photovoltaic cells from metallurgical-grade silicon N.
